# EUROPEAN PATENT APPLICATION

(11) **EP 0 987 752 A2**
(43) Date of publication of application: **22.03.2000**
(21) Application number: 99307304.8
(22) Date of filing: 15.09.1999
(51) Int. Cl.: H01L 21/768

(54) **Improved-reliability damascene interconnects and process of manufacture**

(30) Priority: 18.09.1998 US 157104
(71) Applicant: International Business Machines Corporation, Armonk, NY 10504 (US); SIEMENS AKTIENGESELLSCHAFT, 80333 München (DE)
(72) Inventor: Clevenger, Larry, c/o IBM United Kingdom Ltd., Winchester, Hampshire SO21 2JN (GB); Filippi, Ronald G., c/o IBM United Kingdom Ltd., Winchester, Hampshire SO21 2JN (GB); Gambino, Jeffrey, c/o IBM United Kingdom Ltd., Winchester, Hampshire SO21 2JN (GB); Gignac, Lynne, c/o IBM United Kingdom Ltd., Winchester, Hampshire SO21 2JN (GB); Hurd, Jeffrey, deceased (GB); Hoinkis, Mark, c/o IBM United Kingdom Ltd., Winchester, Hampshire SO21 2JN (GB); Iggulden, Roy C., c/o IBM United Kingdom Ltd., Winchester, Hampshire SO21 2JN (GB); Mehter, Ebrahim, c/o IBM United Kingdom Ltd., Winchester, Hampshire SO21 2JN (GB); Rodbell, Kenneth P., c/o IBM United Kingdom Ltd., Winchester, Hampshire SO21 2JN (GB); Schnabel, Florian., c/o IBM United Kingdom Ltd., Winchester, Hampshire SO21 2JN (GB); Weber, Stefan J., c/o IBM United Kingdom Ltd., Winchester, Hampshire SO21 2JN (GB)
(74) Representative: Boyce, Conor

(57) **Abstract**

An improved-reliability conductive damascene structure in a depression within an insulator layer of a semiconductor substrate and its process of manufacture. The process comprises depositing a wetting layer having a first metal in contact with the insulator layer in the depression, uniformly depositing a barrier layer over the wetting layer, and depositing a conductive layer having a second metal over the barrier layer. The conductive layer deposition step is performed at a temperature below which the first and second metals diffuse through the barrier layer to create intermetallic compounds of the first and second metals.

## Description

The present invention relates to the manufacture of semiconductor chips and, more specifically, to improved-reliability damascene interconnects, having reduced intermetallic formation between the conductive and wetting layers, and to the process for manufacturing such interconnects.

In semiconductor chip design, the various micro-electrical components such as transistors, capacitors, and the like that comprise the working components of an integrated circuit are connected together by metal interconnects, typically aluminum (Al) or some alloy of aluminum. Usually, the interconnects comprise more than one metal layer deposited one top of another in a trench, or damascene structure, that has been etched in a dielectric layer that isolates each trench from another. Typically these damascene structures are laid out in pairs designated as dual damascene structures.

Often interconnects suffer from "electro-migration," defined as the material transport induced by the electron flow during operation under current. The sidewall interface between the interconnect and the surrounding dielectric has been identified as one primary path for the material transport in metal lines. The metal grain boundaries are another pathway. The use of interconnects having redundant layers such as wetting layers, barrier layers, and liners between the dielectric and the metal layer has greatly reduced the electromigration problem from historic levels experienced in early integrated circuit design. Electromigration still occurs, however, to the typical sidewall liners used in the art. With the size of the lateral and vertical dimensions of interconnect lines constantly shrinking to create more functionality on smaller chips, the goal of increasing the "electromigration lifetime" until interconnect failure is an increasingly important consideration.

The present invention increases quantitatively the electromigration lifetime of metal lines by limiting or stopping the formation of intermetallics within the interconnection network. Intermetallics are typically formed when the metal layer reacts with the wetting layer. High temperatures during the metal layer deposition step, non-uniformities in the barrier layer, or both high temperatures and non-uniformities can exacerbate this reaction. As contact sizes have decreased in the semiconductor industry, deposition temperatures have increased while uniformity of barrier layer coverage has decreased, thus allowing such intermetallic formation. Intermetallic formation consumes metal from the metal line during the manufacturing process, thus reducing the amount of metal before current flows and electromigration begins.

It is an object of the present invention to provide a metal deposition process that will limit the amount of intermetallic formation within a conductive line deposited over a wetting layer. More specifically, an object of the present invention is to limit the TiAl₃ formation within an Al line deposited over a Ti wetting layer.

To achieve these and other objects, and in view of its purposes, the present invention provides a process for manufacturing a conductive damascene structure in a depression within an insulator layer on a semiconductor substrate. This process comprises depositing a wetting layer having a first metal in contact with the insulator in the depression, depositing a uniform barrier layer over the wetting layer, and depositing a conductive layer having a second metal over the barrier layer. The conductive layer deposition step is performed at a temperature below the temperature at which the first and second metals diffuse through the barrier layer to react with one another to create intermetallic compounds of the first and second metals.

The barrier layer may comprise any composition that has a higher diffusion temperature for the first and second metals than the reaction temperature of the first metal with the second metal. The second metal may be deposited by Chemical Vapor Deposition (CVD). The first metal may be titanium and the second metal may be aluminum. The barrier layer may comprise a component selected from the group consisting of Titanium Nitride (TiN), Tantalum Nitride (TaN), Tungsten (W), Tungsten Nitride (WN), Titanium Aluminide (TiAl₃), and combinations of those materials.

The resulting conductive damascene structure comprises a wetting layer having a first metal in contact with the insulator in the depression; a uniform barrier layer over the wetting layer; and a conductive layer having a second metal over the barrier layer. The barrier layer comprises a composition that prevents diffusion of the first and second metals through the barrier layer below a diffusion temperature that is greater than the reaction temperature at which the first and second metals react with one another.

It is to be understood that both the foregoing general description and the following detailed description are exemplary, but are not restrictive, of the invention.

The invention is best understood from the following detailed description when read in connection with the accompanying drawing. It is emphasized that, according to common practice, the various features of the drawing are not to scale. On the contrary, the dimensions of the various features are arbitrarily expanded or reduced for clarity. Included in the drawing are the following figures:
Fig. 1 is a schematic illustration of a cross-section of an insulator layer having two depressions: a single damascene structure on the left and a dual damascene structure on the right;
Fig. 2 is a schematic illustration of a cross-section of the insulator layer shown in Fig. 1 having a wetting layer deposited in the depressions;
Fig. 3 is a schematic illustration of a cross-section of the insulator layer shown in Fig. 2 having a barrier layer deposited on the wetting layer;
Fig. 4 is a schematic illustration of a cross-section of the insulator layer shown in Fig. 3 having a conductive layer deposited on the barrier layer;
Fig. 4A is a schematic illustration of a cross-section of the insulator layer shown in Fig. 4 after a standard removal process has removed the wetting, barrier, and metal layer components deposited on the top of the insulator layer;
Fig. 5 is a schematic illustration of a top view of a typical reliability test circuit structure;
Fig. 5A is a schematic illustration taken along the line 5A-5A of Fig. 5; and
Fig. 5B is a schematic illustration taken along the line 5B-5B of Fig. 5.

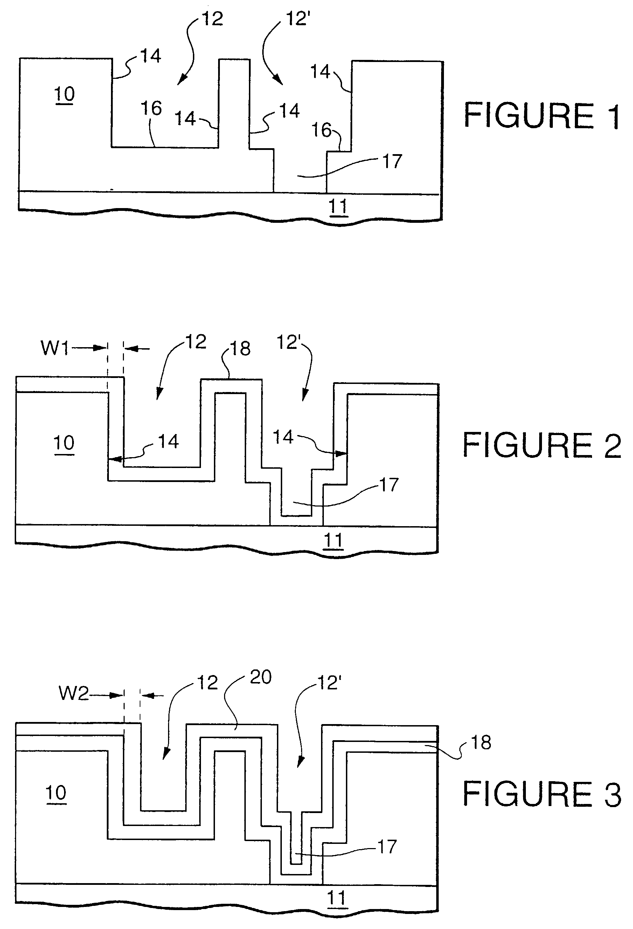

Referring now to the drawing, wherein like reference numerals refer to like elements throughout, Fig. 1 shows an insulator layer 10 made of a non-conductive material such as silicon oxide. Insulator layer 10 may be atop a substrate 11, such as a silicon wafer. Other layers (not shown) may be disposed between substrate 11 and insulator layer 10. Depressions 12 and 12', which may also be referred to as trenches or damascene structures, in insulator layer 10 may be formed by any method well known in the art, such as reactive ion etching. Depression 12 is known as a single damascene structure, whereas depression 12' is known as a dual damascene structure. Each depression 12, 12' has two sidewalls 14 and a bottom 16. Depression 12' has via 17 extending from its bottom 16 to the bottom of insulator layer 10.

Referring now to Fig. 2, there is shown a schematic cross-sectional illustration of the insulator layer 10 of Fig. 1 with a wetting layer 18 applied in depressions 12 and 12'. Wetting layer 18 is a metal, such as titanium (Ti), having a thickness "W1" deposited on sidewalls 14. Wetting layer 18 may be deposited by collimated or ionized Physical Vapor Deposition (PVD), by CVD, or by any process known in the art.

Referring now to Fig. 3, there is shown a schematic cross-sectional illustration of the insulator layer 10 of Fig. 2 with a barrier layer 20 formed over wetting layer 18. Barrier layer 20 is a non-reactive compound, such as titanium nitride (TiN), having a sidewall thickness "W2" preferably between 10 and 1,000 Angstroms, more preferably between 50 and 500 Angstroms. The barrier layer sidewall thickness depends, in part, on the size of via 17; barrier layer 20 cannot be so thick as to close via 17. Sidewall thickness W2 of barrier layer 20 should be thicker, more uniform, or both thicker and more uniform, however, than sidewall thickness W1 of wetting layer 18. Uniformity and thickness are necessary so that there are no thin spots where the conductive layer can break through barrier layer 20 to react with wetting layer 18.

Barrier layer 20 comprises any material that has a higher diffusion temperature for the components of the wetting layer 18 and the metal layer (described below) than the reaction temperature for those components. Titanium Nitride (TiN) is preferred. Other barrier layer materials may comprise, but are not limited to, Tantalum Nitride (TaN), Tungsten (W), Tungsten Nitride (WN), Titanium Aluminide (TiAl₃), and any combination of those materials. Typically, barrier layer 20 is deposited by Chemical Vapor Deposition (CVD) for optimal uniformity, especially if wetting layer 18 is non-uniform, such as when deposited by a method other than CVD, or where sidewalls 14 are straight rather than tapered. If sidewalls 14 are tapered, or if wetting layer 18 is uniform such as when deposited by CVD, other barrier layer deposition methods may produce acceptable uniform coverage of wetting layer 18.

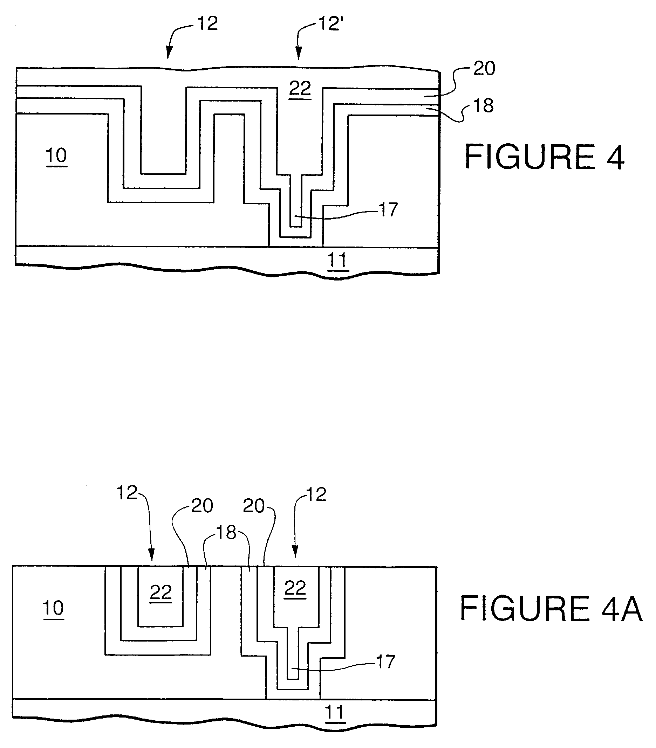

Referring now to Fig. 4, insulator layer 10 of Fig. 3 is shown with conductive layer 22 completely filling depressions 12 and 12'. Conductive layer 22 is typically a metal such as aluminum (Al).

Conductive layer 22 may also be a multi-layered conductive layer comprising Al overlaid with an aluminum-copper alloy (AlCu). The process and structure of the present invention could also be used with damascene interconnects based on other metals, such as Copper (Cu).

Fig. 4A illustrates insulator layer 10 of Fig. 4 after a standard removal process known in the art, such as a chemical-mechanical polishing (CMP) step. The process removes the wetting, barrier, and metal layer components deposited on the top of insulator layer 10. Thus, after application of the removal process, these layers remain only in the depressions 12, 12'.

The process of the present invention yields an associated resulting structure with minimum intermetallics in the interconnect structures. The process achieves this result by maximizing uniformity of the barrier layer coverage and by minimizing the conductive layer deposition temperature. The reaction between titanium and aluminum begins at 350âC. On the other hand, when a TiN barrier layer 20 is used, the reaction between the Ti in wetting layer 18 and the Al in conductive layer 22 cannot take place below 430âC. Only above 430âC. do Ti from wetting layer 18 and Al from conductive layer 22 diffuse through the TiN barrier layer 20 and react with each other. At lower temperatures, the TiN barrier layer 20 acts as an impermeable membrane through which the Ti and Al cannot diffuse and come in contact with one another to react.

Thus, the maximum deposition temperature is controlled by the diffusion properties of the membrane (i.e., barrier layer 20). When a TiN barrier layer 20 uniformly covers wetting layer 18, an aluminum deposition temperature of up to 430âC. may be used without creating intermetallic TiAl₃. Other barrier layer compositions (as well as other wetting and conductive layer metals) may produce different maximum deposition temperatures.

Although reaction between the Ti in wetting layer 18 and Al in conductive layer 22 must be avoided, TiAl₃ itself may be used for barrier layer 20. A TiAl₃ barrier layer 20 is possible because it is not the presence of TiAl₃ that must be avoided. Rather, the loss of metal due to the reaction, which reduces the electromigration lifetime of the interconnect by reducing the amount of metal available before the device is even put into service, must be avoided.

The following example is included to more clearly demonstrate the overall nature of the invention. This example is exemplary, not restrictive, of the invention.

Dual damascene structures were filled with interconnects having various metallization schemes involving Ti, TiN, and AlCu materials deposited by various mechanisms in various thicknesses at various temperatures. The interconnects were formed on a 1 x 1 reliability test structure, a standard yield test circuit well known in the art.

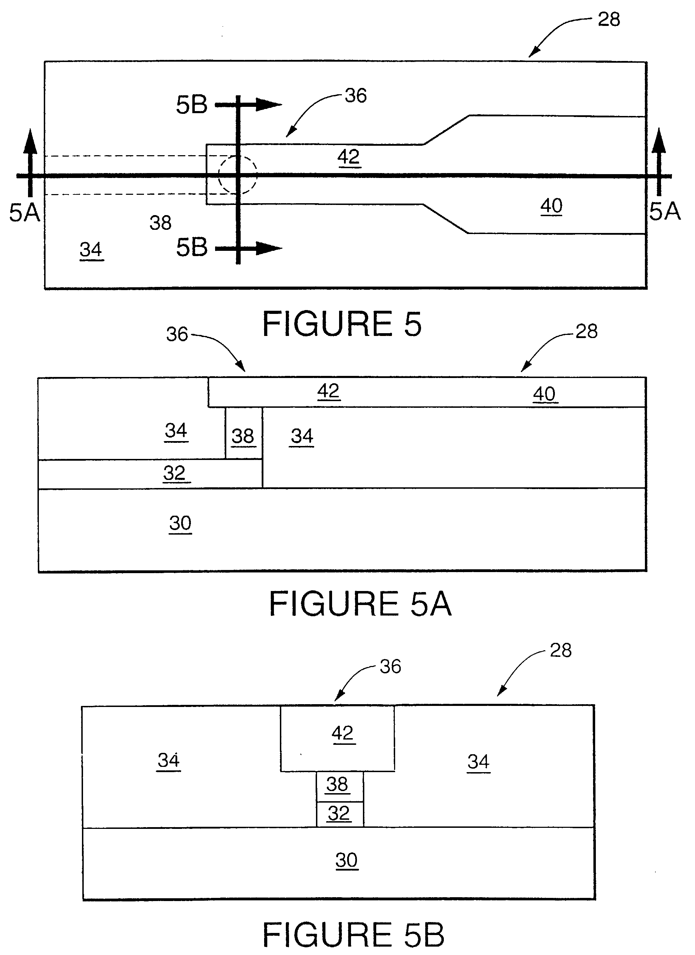

Referring now to Figs. 5, 5A, and 5B, there are shown schematic illustrations of a typical configuration of a 1 x 1 reliability test circuit structure 28. Test circuit structure 28 has a substrate 30 onto which current-carrying metal line 32 is deposited. An insulating dielectric layer 34 is deposited over the current-carrying metal line 32, and a dual damascene structure comprising damascene structure 36 and via 38 is formed in dielectric layer 34.

A cross section through damascene structure 36 and via 38 is shown generally in Fig 5B, showing only conductive layer 42 without detailed wetting and barrier layers, for purposes of clarity. Via 38 connects damascene structure 36 to current-carrying metal line 32. Damascene structure 36 is connected to an aluminum reservoir 40 that, in turn, is connected to ground. Aluminum reservoir 40 is essentially a conductive structure having a much larger amount of metal than via 38 and dual damascene structure 36. Consequently, electromigration effects will cause failure first on the critical structure being tested (i.e., on via 38 and dual damascene structure 36) rather than at the connection to ground.

To conduct a test, current metal line 32 is attached to a power supply, allowing power to flow through via 38, into dual damascene structure 36, and to reservoir 40. The initial resistance is measured across dual damascene structure 36, and the resistance is monitored throughout the test. Circuit failure is characterized as the time when the resistance increases to 120% of the original resistance. Typically, between 40 to 100 test circuits similar to the one shown in Figs. 5, 5A, and 5B are created for the type of damascene structure to be tested. The resistance is tracked for each of the plurality of test circuits for each type of damascene structure, and a t50 value is recorded. The t50 value represents the number of hours after which 50% of the circuits of a particular type of damascene structure fail.

Tests of various damascene structures were conducted with a test circuit structure similar to, but not necessarily exactly like, test circuit structure 28. Tests were conducted with each circuit at 250âC and carrying a current of 10 mA/µm² (milliamps/square micron). For the tests described, the dual damascene structure 36 further included one or more layers between the trench wall of the insulating dielectric layer 34 and conductive layer 42, depending on the metallization scheme (the specific compositions of the wetting layer, conductive layer, and barrier layer where present, the thicknesses of those layers, and other process parameters) being tested. The metallization schemes tested, the conductive layer (Al) deposition temperatures for each scheme, and the result obtained in each case are shown in Table 1. The highest t50 value indicates the metallization scheme producing the interconnect structure with the longest life.

**TABLE 1**

| **Sample Name** | **Metallization Scheme*** | Al dep. Temp. (°C) | t50 (hours) |
|---|---|---|---|
| A | 250Ti/AlCuSi/AlCu | 525 | 1.1 |
| B | 250Ti/AlCuSi/AlCu | 480 | 7 |
| C | 250Ti/AlCu | 460 | 5.1 |
| D | 200Ti/100CVD TiN/600CVD Al/AlCu | 400 | 100 |
| E | 250Ti/AlCu/Forcefill | 450 | 18.7 |
| F | 250Ti/AlCu/Forcefill | 490 | 13.6 |
| G | 250Ti/100TiN/AlCu/Forcefill | 450 | 1.8 |
| H | 250Ti/100TiN/AlCu/Forcefill | 490 | 1.2 |

| | | | |
|---|---|---|---|
| * Each notation separated by backslashes denotes a distinct layer or process step, deposited or performed in the order recited; numbers in front of the metal designations (e.g., 250Ti) signify the thickness of the layer in Angstroms. | | | |

Table 1 shows that sample D, having a barrier layer between the Ti and the Al layers, and having the lowest aluminum deposition temperature, had the highest t50 value. Each of the samples having a process step or structure conducive to TiAl₃ formation showed lower t50 values. For example, samples C, E, and F had no barrier layer; samples A and B had high Al deposition temperatures; and samples E, F, G, and H all included a force-fill step after conductive layer deposition. A force-fill step comprises subjecting the structure to high temperatures greater than the Al deposition temperature and typically under pressure, to reflow the Al after deposition to "force" it to more tightly "fill" the damascene structures without voids. Therefore, although sample G was prepared with a barrier layer and a low Al deposition temperature, the exposure to the high temperatures of the force-fill step still created the intermetallic. This result demonstrates the importance of providing both a barrier layer and maintaining a temperature throughout processing below the diffusion temperature of Al and Ti through the barrier layer.

Thus, sample D showed the highest t50. Sample D had a 100 Angstrom barrier layer of TiN deposited by CVD for uniformity, and an aluminum deposition temperature of 400âC. The 400âC temperature is less than the diffusion temperature (about 430âC) of Al and Ti through TiN. Tunneling Electron Microscope (TEM) analysis of each of the sample types showed significant formation of TiAl₃ between the conductive and barrier layers of each of the sample types except sample D. A metallization scheme having a layer structure similar to sample D (PVD Ti/CVD TiN/CVD Al/PVD Al) but with an Al deposition temperature of 460âC, also showed significant formation of TiAl₃ between the conductive and barrier layers under TEM analysis.

Although illustrated and described herein with reference to certain specific embodiments, the present invention is nevertheless not intended to be limited to the details shown. Rather, various modifications may be made in the details within the scope and range of equivalents of the claims and without departing from the spirit of the invention.

## Claims

1. A process for manufacturing a conductive damascene structure in a depression (12,12') within an insulator layer (10) on a semiconductor substrate (11) , the damascene structure comprising a wetting layer (18) of a first metal and a conductive layer (22) of a second metal, said first metal and said second metal having a reaction temperature at which they react with one another to create an intermetallic compound, the process being characterised by:
a) depositing the wetting layer (18) in contact with said insulator (10) in said depression (12,12');
b) depositing a uniform barrier layer (20) over said wetting layer (18), said barrier layer comprising a composition that prevents diffusion of said first and second metals (18,22) therethrough below a diffusion temperature that is greater than said reaction temperature; and
c) depositing said conductive layer (22) over said barrier layer (20) at a temperature no greater than said diffusion temperature.

2. The process for manufacturing a conductive damascene structure according to claim 2 wherein step (b) further comprises depositing said barrier layer by chemical vapor deposition.

3. The process for manufacturing a conductive damascene structure according to claim 1 wherein the first metal comprises Ti and the second metal comprises Al.

4. The process for manufacturing a conductive damascene structure according to claim 3 wherein the barrier layer comprises a component selected from the group consisting of TiN, TaN, TiA13, W, WN, and combinations thereof.

5. The process of manufacturing a conductive damascene structure according to claim 4 wherein said barrier layer is TiN and said diffusion temperature is about 430ÔC.

6. The process for manufacturing a conductive damascene structure according to claim 1 wherein no manufacturing steps following step (c) are performed at a temperature greater than said diffusion temperature.

7. A conductive damascene structure in a depression (12,12') within an insulator layer (10) on a semiconductor substrate (11), the structure being characterised by:
a wetting layer (18) having a first metal in contact with said insulator layer in said depression;
a uniform barrier layer (20) over said wetting layer; and
a conductive layer (22) having a second metal over said barrier layer;
wherein said barrier layer (20) has a diffusion temperature that is greater than a reaction temperature at which said first and second metals react with one another.

8. The conductive damascene structure according to claim 7 wherein the first metal comprises Ti and the second metal comprises Al.

9. The conductive damascene structure according to claim 8 wherein the barrier layer comprises a component selected from the group consisting of TiN, TaN, TiAl3, W, WN, and combinations thereof.

10. The conductive damascene structure according to claim 8 wherein the damascene structure is a dual damascene structure (12').
